# EUROPEAN PATENT SPECIFICATION

(11) **EP 4 414 121 B1**
(45) Date of publication and mention of the grant of the patent: **16.09.2026**
(21) Application number: 23868582.0
(22) Date of filing: 20.09.2023
(51) Int. Cl.: B23K 31/12, H01M 50/516, G01N 27/20, G01N 25/72, B23K 101/36, B23K 31/02, H01M 10/42

(54) **BATTERY CELL WELDED PART INSPECTION APPARATUS, AND BATTERY CELL WELDED PART INSPECTION METHOD USING SAME**
VORRICHTUNG ZUR INSPEKTION VON BATTERIEZELLENGESCHWEISSTEN TEILEN UND VERFAHREN ZUR INSPEKTION VON BATTERIEZELLENGESCHWEISSTEN TEILEN DAMIT
APPAREIL D'INSPECTION DE PIÈCE SOUDÉE D'ÉLÉMENT DE BATTERIE, ET PROCÉDÉ D'INSPECTION DE PIÈCE SOUDÉE D'ÉLÉMENT DE BATTERIE LE METTANT EN OEUVRE

(30) Priority: 21.09.2022 KR 20220119053
(43) Date of publication of application: 14.08.2024
(73) Proprietor: LG Energy Solution, Ltd., Seoul 07335 (KR)
(72) Inventor: JEUNG, Seok Won, Daejeon 34122 (KR); KANG, Choon Kwon, Daejeon 34122 (KR); OH, Hyun Min, Daejeon 34122 (KR)
(74) Representative: Plasseraud IP
(86) International application number: PCT/KR2023/014259
(87) International publication number: WO 2024/063530

(56) References cited:
- CN-A- 103 730 694
- CN-A- 109 738 456
- JP-A- 2000 100 465
- JP-A- 2020 068 593
- KR-B1- 101 069 162

## Description

### [Technical Field]

This application claims the benefit of priority to Korean Patent Application No. 2022-0119053 filed on September 21, 2022.

The present invention relates to a battery cell weld inspection apparatus and a battery cell weld inspection method using the same. More particularly, the present invention relates to a battery cell weld inspection apparatus capable of performing final inspection of all defective battery cells without omission during manual inspection of battery cells determined to have defective welds through voltage and current measurement and temperature measurement and a battery cell weld inspection method using the same.

### [Background Art]

Due to high energy density and high charging voltage thereof, a lithium secondary battery, which is charged and discharged by the movement of lithium ions, has been used not only in the field of small battery cells for mobile devices and small electronic products but also in the field of medium and large battery packs used as energy sources for electric vehicles and power storage systems that require high power and high voltage.

In order to manufacture the medium and large battery pack, it is necessary to electrically connect the plurality of cylindrical battery cells to each other. For example, a method of connecting a metal plate to positive electrode terminals and negative electrode terminals of the cylindrical battery cells by wire welding may be used.

At this time, if coupling between wires and the positive electrode terminals and the negative electrode terminals of the cylindrical battery cells is weak, the wires may be detached from the positive electrode terminals and the negative electrode terminals of the cylindrical battery cells due to impact. If coupling between the wires and the positive electrode terminals and the negative electrode terminals of the cylindrical battery cells is strong, on the other hand, a gasket may be damaged, causing electrolyte leakage or electrical disconnection.

Such problems may degrade the performance of the cylindrical battery cells or may cause safety problems.

Therefore, it is necessary to check the welding state of welds without omission before assembly of the battery pack in order to prevent the above problems from occurring.

However, the number of battery cells constituting a large battery pack, such as in an electric vehicle, is increasing to 600 or 700, making it substantially impossible to manually inspect all of the battery cells in order to determine whether the battery cells are defective.

In recent years, therefore, a method of identifying battery cells having defective welds through a direct current internal resistance (DCIR) test, which measures voltage and current of the cells to check resistance thereof has been used.

In addition, a method of photographing a weld of a battery cell using a thermal imaging scanner to determine whether the temperature distribution is within a normal range is used.

In this regard, Patent Document 1 discloses a weld quality inspection system for inspecting a weld of a battery for vehicles, wherein current is supplied to the weld to measure voltage generated at the weld.

Patent Document 1 suggests a simple method of inspecting the weld quality of welds of batteries of various sizes but does not suggest a method of displaying a defective battery cell.

After identifying battery cells having defective welds using the method of measuring voltage and current or the method of photographing the temperature of the weld, as described above, an operator may individually manually pull welding wires of the battery cells having the defective welds to finally determine whether the welds are defective, whereby it is possible to determine whether the battery cells pass or fail.

However, defective battery cells may be assembled into a battery pack without being identified in the final stage due to operator error. Consequently, it is necessary to check welds of battery cells sorted as defective battery cells without omission in order to prevent distribution of the defective battery cells.

### (Prior Art Document)

(Patent Document 1) Korean Registered Patent Publication No. 1887148 (2018.08.03)

### [Disclosure]

### [Technical Problem]

The present invention has been made in view of the above problems, and it is an object of the present invention to provide a battery cell weld inspection apparatus capable of preventing inspection of battery cells having defective welds from being missed, thereby preventing the distribution of defective battery cells, and a battery cell weld inspection method using the same.

### [Technical Solution]

A battery cell weld inspection apparatus according to the present invention to accomplish the above object includes a plate configured to allow a battery cell cassette having a plurality of battery cells disposed therein to be mounted thereon, an orthogonal robot configured to move above the battery cell cassette fixed to the plate, a laser pointer coupled to the orthogonal robot, the laser pointer being configured to mark a defective battery cell among the plurality of battery cells, and an alignment unit configured to align the position of the battery cell cassette such that the battery cell cassette is disposed in an operation zone of the orthogonal robot.

The battery cell weld inspection apparatus may further include a controller configured to receive position information of a weld of the defective battery cell derived from an internal resistance value of the battery cell cassette and the result of measurement using a thermal imaging scanner and to control the orthogonal robot based on the received position information.

The laser pointer may radiate a laser beam to a weld of each of a positive electrode terminal and a negative electrode terminal of the defective battery cell.

The battery cell weld inspection apparatus may further include a lift configured to adjust the height of the plate, wherein the lift may be located under the plate.

The battery cell cassette may include four corner portions, each of which is formed as the result of two side surfaces being joined to each other, and the alignment unit may align the battery cell cassette while moving so as to be closer to or farther away from the four corner portions.

The plate may include a coupling portion configured to fix the position of the battery cell cassette.

The battery cell weld inspection apparatus may further include a count display unit configured to display the number of the defective battery cells.

The battery cell weld inspection apparatus may further include a manual inspector configured to enable an operator to manually inspect a weld of the defective battery cell marked by the laser pointer.

The manual inspector may include a push-pull jig configured to pull a wire of the weld of the defective battery cell and an alarm unit configured to generate an alarm when force with which the push-pull jig pulls the wire reaches a set level.

The number displayed on the count display unit may be decreased whenever the operator checks the weld of the defective battery cell marked by the laser pointer.

The present invention provides a battery cell weld inspection method using the battery cell weld inspection apparatus, the battery cell weld inspection method including the steps of disposing a battery cell cassette having a plurality of battery cells mounted therein on the plate, aligning the position of the battery cell cassette using the alignment unit, transmitting position information of a weld of a defective battery cell to the orthogonal robot, marking the weld of the defective battery cell using the laser pointer through movement of the orthogonal robot, and pulling the weld of the defective battery cell marked by the laser pointer using the manual inspector for inspection thereof, wherein the position information of the weld of the defective battery cell is obtained from the result of measurement of the internal resistance of the battery cell cassette and the result of measurement using the thermal imaging scanner performed in advance.

Upon completion of a manual inspection of a specific one of a plurality of defective battery cells, a laser beam of the laser pointer may mark another defective battery cell, and wherein, when there is a further defective battery cell after completion of the manual inspection of the other defective battery cell, the laser beam may be radiated to the further defective battery cell and the further defective battery cell may be manually inspected.

The number of the defective battery cells may be displayed on the count display unit as figures, the number on the count display unit may decrease by one whenever the wire of the weld of the defective battery cell is pulled in the manual inspection step, and an operator may pull wires of welds of all defective battery cells to inspect the welds until the number displayed on the count display unit reaches zero.

The inspection step using the manual inspector may be performed through a process of pulling the wire of the weld of the defective battery cell until the manual inspector generates an alarm.

In addition, the present invention may provide various combinations of the above solving means.

### [Advantageous Effects]

As is apparent from the above description, when a battery cell weld inspection apparatus according to the present invention is used, it is possible to display the number of all battery cells determined to have defective welds and to directly mark the welds of the defective battery cells using a laser pointer, whereby it is possible to easily identify the defective battery cells and to perform final inspection.

In addition, when a battery cell weld inspection method according to the present invention is used, it is possible to manually inspect all defective battery cells, whereby it is possible to prevent the defective battery cells from being missed in the final inspection stage, and therefore it is possible to prevent distribution of the defective battery cells.

### [Description of Drawings]

FIG. 1 is a perspective view of a battery cell weld inspection apparatus according to the present invention.
FIG. 2 is a partial enlarged view of FIG. 1.
FIG. 3 is a plan view of a battery cell cassette.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that such elements may be further included unless mentioned otherwise.

In addition, a description to embody elements through limitation or addition may be applied to all inventions, unless particularly restricted, and does not limit a specific invention.

Also, in the description of the invention and the claims of the present application, singular forms are intended to include plural forms unless mentioned otherwise.

Also, in the description of the invention and the claims of the present application, "or" includes "and" unless mentioned otherwise. Therefore, "including A or B" means three cases, namely, the case including A, the case including B, and the case including A and B.

Hereinafter, embodiments of the present invention will be described in detail with reference to the drawings.

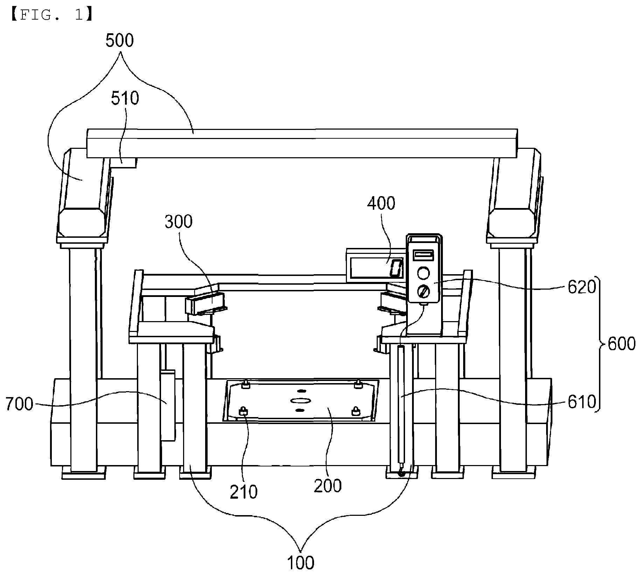

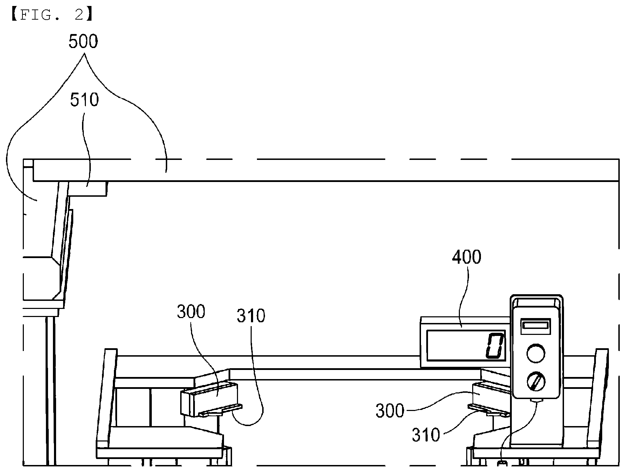

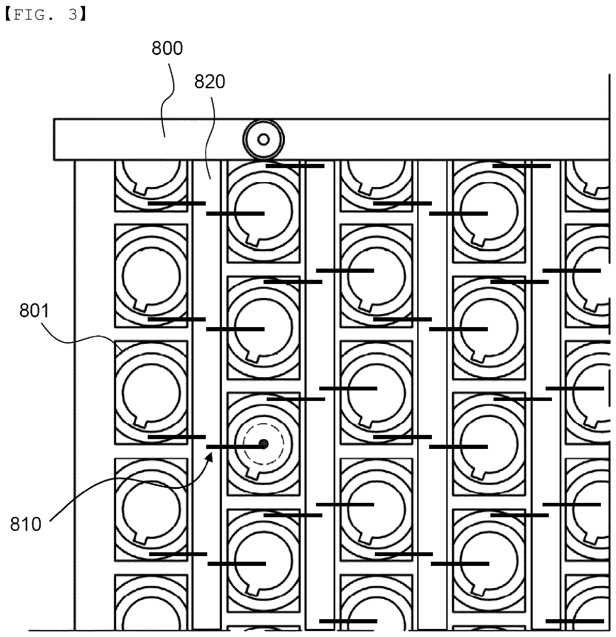

FIG. 1 is a perspective view of a battery cell weld inspection apparatus according to the present invention, FIG. 2 is a partial enlarged view of FIG. 1, and FIG. 3 is a plan view of a battery cell cassette.

Referring to FIGS. 1 to 3, the battery cell weld inspection apparatus according to the present invention includes a plate 200 configured to allow a battery cell cassette, in which a plurality of battery cells is disposed through a holder and a frame, to be mounted thereon, an orthogonal robot 500 configured to move above the battery cell cassette fixed to the plate 200, a laser pointer 510 coupled to the orthogonal robot 500, the laser pointer being configured to mark a defective battery cell among the plurality of battery cells, an alignment unit 300 configured to align the position of the battery cell cassette such that the battery cell cassette is disposed in an operation zone of the orthogonal robot 500, and a manual inspector 600 configured to enable an operator to manually inspect a weld of the defective battery cell marked by the laser pointer 510.

In addition, the battery cell weld inspection apparatus includes a housing 100 configured to allow components of the battery cell weld inspection apparatus to be disposed therein, the housing being a space in which the operator performs manual inspection when the defective weld is marked by the laser pointer.

The battery cell weld inspection apparatus according to the present invention is used in the final stage of determining whether wire welds coupled to a positive electrode terminal and a negative electrode terminal of a cylindrical battery cell are defective. Consequently, a battery cell having a defective weld is specified through DCIR and a thermal imaging scanner before the final inspection is performed using the battery cell weld inspection apparatus according to the present invention, and relevant information is transmitted to the battery cell weld inspection apparatus.

The battery cell weld inspection apparatus includes a controller 700 configured to receive position information of the weld of the defective battery cell obtained through an internal resistance value derived from the result of measurement of voltage and current of the battery cell cassette and through the result of temperature distribution measured using the thermal imaging scanner and to control the orthogonal robot based on the received position information.

The controller 700 performs control such that the orthogonal robot 500 moves in a two-dimensional plane in a forward-backward direction and a leftward-rightward direction, and the laser pointer 510 coupled to the orthogonal robot 500 radiates a laser beam to the defective battery cell in order to visually inform that the battery cell irradiated with the laser beam is a defective battery cell.

Specifically, as shown in FIG. 3, in the state in which a plurality of battery cells 801 is mounted in a battery cell cassette 800 and wires 810 are coupled to a metal plate 820 by welding, the laser pointer 510 may radiate a laser beam to a positive terminal weld of a defective battery cell to which a wire is welded, as indicated by a dotted circle in FIG. 3.

The laser beam may be individually radiated to a positive terminal weld and/or a negative terminal weld, and therefore it is possible to more specifically determine whether the positive terminal weld of the defective battery cell is defective or the negative terminal weld of the defective battery cell is defective.

Consequently, the present invention provides very good visibility for the operator to identify a defective battery cell for manual inspection.

In order for the laser pointer 510 to mark a weld of a defective battery cell, the battery cell cassette 800 must be disposed in an area in which marking by the laser pointer is possible. When the battery cell cassette 800 is disposed on the plate 200, the alignment unit 300 aligns the position of the battery cell cassette 800 such that the battery cell cassette is disposed in an area in which marking by the laser pointer is possible.

Specifically, the battery cell cassette 800 includes four corner portions, each of which is formed as the result of two side surfaces being joined to each other, and the alignment unit 300 aligns the battery cell cassette 800 while moving so as to be closer to or farther away from the four corner portions.

Referring to FIG. 2, a guide 310 having concave recesses, into which the corner portions of the battery cell cassette 800 are inserted, formed therein is provided at a lower end of the alignment unit 300.

The plate 200 includes a coupling portion 210 formed so as to protrude upward from an upper surface thereof in order to fix the position of the battery cell cassette 800. The coupling portion 210 includes four coupling portions 210 disposed adjacent to the four corner portions of the battery cell cassette 800. A recess, into which the coupling portion 210 is inserted, is formed in a lower surface of the battery cell cassette 800, and the battery cell cassette 800 is disposed such that the coupling portion 210 is inserted into the recess, whereby the position of the battery cell cassette may be fixed.

In addition, a lift configured to adjust the height of the plate 200 may be provided under the plate, wherein the battery cell cassette 800 is mounted to the upper surface of the plate 200, and the battery cell cassette may be moved upward to the height of the alignment unit 300 using the lift. At this time, the battery cell cassette 800 may be held in place by the coupling portion 210 without wobbling or shifting.

The present invention includes a count display unit 400 configured to display the number of defective battery cells. The controller 700 may receive the number of defective battery cells along with the position of the defective battery cells, and the count display unit 400 may display the number of battery cells having defective welds as figures such that the operator can recognize the number of the defective battery cells.

Specifically, the count display unit 400 displays the number of defective welds of all of the battery cells included in the battery cell cassette 800, and "2" is displayed when each of a positive electrode terminal and a negative electrode terminal of one battery cell includes a defected weld.

The count display unit 400 is configured to decrease the number displayed thereon whenever an operator checks a weld of a defective battery cell marked by the laser pointer 510 using the manual inspector 600. For example, when "2" is initially displayed on the count display unit, which means that the total number of defective welds is two, and the operator completes inspecting one of the defective welds, the number on the count display unit is changed to "1", and when the operator completes inspecting the other defective weld, the number on the count display unit is changed to "0".

The manual inspector 600 includes a push-pull jig 610 configured to pull a wire of the weld of the defective battery cell and an alarm unit 620 configured to generate an alarm when the force with which the push-pull jig 610 pulls the wire reaches a set tension.

That is, when a tension for pulling a wire is set in the manual inspector 600, the push-pull jig 610 is hooked to the wire 810, and the push-pull jig 610 is pulled, the alarm unit 620 may generate a sound or may emit light if the wire is pulled above the set tension, and the operator releases the push-pull jig 610 from the wire.

For example, the tension may be set as a reference point corresponding to a range within which the coupling force of a weld is normal, and manual inspection may be performed using a method of the operator pulling the wire of the weld of the defective battery cell until the alarm of the manual inspector 600 is generated. At this time, if the wire is detached from the weld before the alarm is generated, which means weak welding, a determination may be made that the weld is defective, and if the wire remains attached to the weld until the alarm is generated, a determination may be finally made that the weld is normal.

The battery cell cassette determined to have the defective battery cell in the final stage, as described above, may be discarded or transferred to a recycling process instead of being transferred to a battery pack assembly process.

A battery cell weld inspection method using the battery cell weld inspection apparatus according to the present invention includes the steps of disposing a battery cell cassette 800 having a plurality of battery cells mounted therein on the plate 200, aligning the position of the battery cell cassette 800 using the alignment unit 300, transmitting the position information of a weld of a defective battery cell to the orthogonal robot 500, marking the weld of the defective battery cell using the laser pointer 510 through the movement of the orthogonal robot 500, and pulling the weld of the defective battery cell marked by the laser pointer 510 using the manual inspector 600 for inspection.

The position information of the weld of the defective battery cell may be obtained from the result of measurement of the internal resistance of the battery cell cassette and the result of measurement using the thermal imaging scanner performed in advance.

In one specific example, upon completion of manual inspection of a specific one of a plurality of defective battery cells constituting the battery cell cassette, a laser beam of the laser pointer 510 may mark another defective battery cell. If there is a further defective battery cell after completion of manual inspection of the other defective battery cell, a laser beam may be radiated to the further defective battery cell and the further defective battery cell may be manually inspected.

Once manual inspection of the weld of any one defective battery cell is completed, as described above, the laser beam may be shifted from the current defective battery cell to the next defective battery cell to visually inform the operator of the defective battery cell. Consequently, the operator may rapidly and accurately check the position of all the defective battery cells and may perform manual inspection.

In the present invention, as described above, only welds of defective battery cells are manually inspected based on data obtained from the result of measurement of the internal resistance of the battery cell cassette and the result of capturing by the thermal imaging scanner performed in advance, and therefore it is possible to more rapidly and accurately determine whether the battery cells are normal or defective than in conventional manual inspection of all battery cells.

In addition, when the battery cell weld inspection method according to the present invention is used, the number of defective welds initially displayed on the count display unit 400 decreases by one whenever the wire of the weld of the defective battery cell is pulled and the alarm unit of the manual inspector generates an alarm.

The operator performs manual inspection of all welds marked by the laser pointer until the number displayed on the count display unit reaches zero, which may prevent defective battery cells from being missed during manual inspection of battery cells having defective welds based on data.

In the present invention, therefore, total inspection of all battery cells is not performed, whereby it is possible to shorten a weld inspection process, and the operator performs manual inspection until the number displayed on the count display unit reaches zero, whereby it is possible to prevent the operator from missing inspection of defective welds in the final inspection stage.

Those skilled in the art to which the present invention pertains will appreciate that various applications and modifications are possible within the scope of the appended claims.

### (Description of Reference Numerals)

- 100:: Housing
- 200:: Plate
- 210:: Coupling portion
- 300:: Alignment unit
- 310:: Guide
- 400:: Count display unit
- 500:: Orthogonal robot
- 510:: Laser pointer
- 600:: Manual inspector
- 610:: Push-pull jig
- 620:: Alarm unit
- 700:: Controller
- 800:: Battery cell cassette
- 801:: Battery cell
- 810:: Wire
- 820:: Metal plate

## Claims

1. A battery cell weld inspection apparatus comprising:
a plate (200) configured to allow a battery cell cassette (800) having a plurality of battery cells (801) disposed therein to be mounted thereon;
an orthogonal robot (500) configured to move above the battery cell cassette (800) fixed to the plate (200);
a laser pointer (510) coupled to the orthogonal robot (500), the laser pointer (510) being configured to mark a defective battery cell among the plurality of battery cells (801); and
an alignment unit (300) configured to align a position of the battery cell cassette (800) such that the battery cell cassette (800) is disposed in an operation zone of the orthogonal robot (500).

2. The battery cell weld inspection apparatus according to claim 1, further comprising:
a controller (700) configured to receive position information of a weld of the defective battery cell derived from an internal resistance value of the battery cell cassette (800) and a result of measurement using a thermal imaging scanner and to control the orthogonal robot (500) based on the received position information.

3. The battery cell weld inspection apparatus according to claim 1, wherein the laser pointer (510) radiates a laser beam to a weld of each of a positive electrode terminal and a negative electrode terminal of the defective battery cell.

4. The battery cell weld inspection apparatus according to claim 1, further comprising:
a lift configured to adjust a height of the plate (200),
wherein the lift is located under the plate (200).

5. The battery cell weld inspection apparatus according to claim 1, wherein the battery cell cassette (800) comprises four corner portions, each of which is formed as a result of two side surfaces being joined to each other, and
wherein the alignment unit (300) aligns the battery cell cassette (800) while moving so as to be closer to or farther away from the four corner portions.

6. The battery cell weld inspection apparatus according to claim 1, wherein the plate (200) comprises a coupling portion (210) configured to fix a position of the battery cell cassette (800).

7. The battery cell weld inspection apparatus according to claim 1, further comprising:
a count display unit (400) configured to display the number of the defective battery cells.

8. The battery cell weld inspection apparatus according to claim 1, further comprising:
a manual inspector configured to enable an operator to manually inspect a weld of the defective battery cell marked by the laser pointer (510).

9. The battery cell weld inspection apparatus according to claim 8, wherein the manual inspector comprises:
a push-pull jig (610) configured to pull a wire (810) of the weld of the defective battery cell; and
an alarm unit (620) configured to generate an alarm when a force with which the push-pull jig (610) pulls the wire (810) reaches a set level.

10. The battery cell weld inspection apparatus according to claim 7, wherein the number displayed on the count display unit (400) is decreased whenever an operator checks the weld of the defective battery cell marked by the laser pointer (510).

11. A battery cell weld inspection method using the battery cell weld inspection apparatus according to any one of claims 1 to 10, the battery cell weld inspection method comprising:
disposing a battery cell cassette (800) having a plurality of battery cells (801) mounted therein on the plate (200);
aligning a position of the battery cell cassette (800) using the alignment unit (300);
transmitting position information of a weld of a defective battery cell to the orthogonal robot (500);
marking the weld of the defective battery cell using the laser pointer (510) through a movement of the orthogonal robot (500); and
pulling the weld of the defective battery cell marked by the laser pointer (510) using the manual inspector for inspection thereof, wherein
the position information of the weld of the defective battery cell is obtained from a result of measurement of the internal resistance of the battery cell cassette (800) and a result of measurement using the thermal imaging scanner performed in advance.

12. The battery cell weld inspection method according to claim 11, wherein
upon completion of a manual inspection of a specific one of a plurality of defective battery cells, a laser beam of the laser pointer (510) marks another defective battery cell, and
wherein, when there is a further defective battery cell after completion of the manual inspection of the other defective battery cell, the laser beam is radiated to the further defective battery cell and the further defective battery cell is manually inspected.

13. The battery cell weld inspection method according to claim 11, wherein the number of the defective battery cells is displayed on the count display unit (400) as figures,
wherein the number on the count display unit (400) decreases by one whenever the wire (810)of the weld of the defective battery cell is pulled in the manual inspection step, and
wherein an operator pulls wires (810) of welds of all defective battery cells to inspect the welds until the number displayed on the count display unit (400) reaches zero.

14. The battery cell weld inspection method according to claim 11, wherein the inspection step using the manual inspector is performed through a process of pulling the wire (810) of the weld of the defective battery cell until the manual inspector generates an alarm.

## Patentansprüche

1. Vorrichtung zur Inspektion von Batteriezellenschweißnähten, umfassend:
eine Platte (200), die so konfiguriert ist, dass eine Batteriezellenkassette (800) mit einer Vielzahl von darin angeordneten Batteriezellen (801) darauf montiert werden kann;
einen orthogonalen Roboter (500), der so konfiguriert ist, dass er sich über der an der Platte (200) fixierten Batteriezellenkassette (800) bewegt;
einen Laserpointer (510), der mit dem orthogonalen Roboter (500) gekoppelt ist, wobei der Laserpointer (510) so konfiguriert ist, dass er eine defekte Batteriezelle unter der Vielzahl von Batteriezellen (801) markiert; und
eine Ausrichtungseinheit (300), die so konfiguriert ist, dass sie eine Position der Batteriezellenkassette (800) so ausrichtet, dass die Batteriezellenkassette (800) in einem Betriebsbereich des orthogonalen Roboters (500) angeordnet ist.

2. Vorrichtung zur Inspektion von Batteriezellenschweißnähten nach Anspruch 1, ferner umfassend:
eine Steuerung (700), die so konfiguriert ist, dass sie Positionsinformationen einer Schweißnaht der defekten Batteriezelle, die aus einem Innenwiderstandswert der Batteriezellenkassette (800) und einem Messergebnis unter Verwendung eines Wärmebildscanners abgeleitet werden, empfängt und den orthogonalen Roboter (500) auf der Grundlage der empfangenen Positionsinformationen steuert.

3. Vorrichtung zur Inspektion von Batteriezellenschweißnähten nach Anspruch 1, wobei der Laserpointer (510) einen Laserstrahl auf eine Schweißnaht sowohl einer positiven Elektrodenklemme als auch einer negativen Elektrodenklemme der defekten Batteriezelle ausstrahlt.

4. Vorrichtung zur Inspektion von Batteriezellenschweißnähten nach Anspruch 1, ferner umfassend:
eine Hebevorrichtung, die so konfiguriert ist, dass sie eine Höhe der Platte (200) einstellt, wobei sich die Hebevorrichtung unter der Platte (200) befindet.

5. Vorrichtung zur Inspektion von Batteriezellenschweißnähten nach Anspruch 1, wobei die Batteriezellenkassette (800) vier Eckabschnitte umfasst, von denen jeder als Ergebnis der Verbindung zweier Seitenflächen gebildet wird, und wobei die Ausrichtungseinheit (300) die Batteriezellenkassette (800) ausrichtet, während sie sich so bewegt, dass sie sich den vier Eckabschnitten nähert oder von ihnen entfernt.

6. Vorrichtung zur Inspektion von Batteriezellenschweißnähten nach Anspruch 1, wobei die Platte (200) einen Kupplungsabschnitt (210) umfasst, der so konfiguriert ist, dass er eine Position der Batteriezellenkassette (800) fixiert.

7. Vorrichtung zur Inspektion von Batteriezellenschweißnähten nach Anspruch 1, ferner umfassend:
eine Zählanzeigeeinheit (400), die so konfiguriert ist, dass sie die Anzahl der defekten Batteriezellen anzeigt.

8. Vorrichtung zur Inspektion von Batteriezellenschweißnähten nach Anspruch 1, ferner umfassend:
eine manuelle Prüfeinrichtung, die so konfiguriert ist, dass sie es einem Bediener ermöglicht, eine Schweißnaht der durch den Laserpointer (510) markierten defekten Batteriezelle manuell zu inspizieren.

9. Vorrichtung zur Inspektion von Batteriezellenschweißnähten nach Anspruch 8, wobei die manuelle Prüfeinrichtung umfasst:
eine Push-Pull-Vorrichtung (610), die so konfiguriert ist, dass sie einen Draht (810) der Schweißnaht der defekten Batteriezelle zieht; und
eine Alarmeinheit (620), die so konfiguriert ist, dass sie einen Alarm erzeugt, wenn eine Kraft, mit der die Push-Pull-Vorrichtung (610) den Draht (810) zieht, ein eingestelltes Niveau erreicht.

10. Vorrichtung zur Inspektion von Batteriezellenschweißnähten nach Anspruch 7, wobei die auf der Zählanzeigeeinheit (400) angezeigte Zahl jedes Mal verringert wird, wenn ein Bediener die Schweißnaht der durch den Laserpointer (510) markierten defekten Batteriezelle prüft.

11. Verfahren zur Inspektion von Batteriezellenschweißnähten unter Verwendung der Vorrichtung zur Inspektion von Batteriezellenschweißnähten nach einem der Ansprüche 1 bis 10, wobei das Verfahren zur Inspektion von Batteriezellenschweißnähten umfasst:
Anordnen einer Batteriezellenkassette (800) mit einer Vielzahl von darin montierten Batteriezellen (801) auf der Platte (200);
Ausrichten einer Position der Batteriezellenkassette (800) unter Verwendung der Ausrichtungseinheit (300);
Übertragen von Positionsinformationen einer Schweißnaht einer defekten Batteriezelle an den orthogonalen Roboter (500);
Markieren der Schweißnaht der defekten Batteriezelle unter Verwendung des Laserpointers (510) durch eine Bewegung des orthogonalen Roboters (500); und Ziehen an der Schweißnaht der durch den Laserpointer (510) markierten defekten Batteriezelle unter Verwendung der manuellen Prüfeinrichtung zu deren Inspektion, wobei
die Positionsinformationen der Schweißnaht der defekten Batteriezelle aus einem Ergebnis der Messung des Innenwiderstands der Batteriezellenkassette (800) und einem Ergebnis der Messung unter Verwendung des im Voraus durchgeführten Wärmebildscanners erhalten werden.

12. Verfahren zur Inspektion von Batteriezellenschweißnähten nach Anspruch 11, wobei nach Abschluss einer manuellen Inspektion einer bestimmten aus einer Vielzahl von defekten Batteriezellen ein Laserstrahl des Laserpointers (510) eine andere defekte Batteriezelle markiert, und wobei, wenn nach Abschluss der manuellen Inspektion der anderen defekten Batteriezelle eine weitere defekte Batteriezelle vorhanden ist, der Laserstrahl auf die weitere defekte Batteriezelle ausgestrahlt wird und die weitere defekte Batteriezelle manuell inspiziert wird.

13. Verfahren zur Inspektion von Batteriezellenschweißnähten nach Anspruch 11, wobei die Anzahl der defekten Batteriezellen auf der Zählanzeigeeinheit (400) als Ziffern angezeigt wird, wobei die Zahl auf der Zählanzeigeeinheit (400) jedes Mal um eins abnimmt, wenn der Draht (810) der Schweißnaht der defekten Batteriezelle im manuellen Inspektionsschritt gezogen wird, und wobei ein Bediener die Drähte (810) der Schweißnähte aller defekten Batteriezellen zieht, um die Schweißnähte zu inspizieren, bis die auf der Zählanzeigeeinheit (400) angezeigte Zahl null erreicht.

14. Verfahren zur Inspektion von Batteriezellenschweißnähten nach Anspruch 11, wobei der Inspektionsschritt unter Verwendung der manuellen Prüfeinrichtung durch einen Prozess des Ziehens des Drahtes (810) der Schweißnaht der defekten Batteriezelle durchgeführt wird, bis die manuelle Prüfeinrichtung einen Alarm erzeugt.

## Revendications

1. Appareil d'inspection de soudure de cellule de batterie comprenant :
une plaque (200) configurée pour permettre à une cassette de cellules de batterie (800) ayant une pluralité de cellules de batterie (801) disposées à l'intérieur de celle-ci d'être montée sur celle-ci ;
un robot orthogonal (500) configuré pour se déplacer au-dessus de la cassette de cellules de batterie (800) fixée à la plaque (200) ;
un pointeur laser (510) couplé au robot orthogonal (500), le pointeur laser (510) étant configuré pour marquer une cellule de batterie défectueuse parmi la pluralité de cellules de batterie (801) ; et
une unité d'alignement (300) configurée pour aligner une position de la cassette de cellules de batterie (800) de sorte que la cassette de cellules de batterie (800) soit disposée dans une zone de fonctionnement du robot orthogonal (500).

2. Appareil d'inspection de soudure de cellule de batterie selon la revendication 1, comprenant en outre :
un contrôleur (700) configuré pour recevoir des informations de position d'une soudure de la cellule de batterie défectueuse dérivées d'une valeur de résistance interne de la cassette de cellules de batterie (800) et d'un résultat de mesure à l'aide d'un scanner d'imagerie thermique et pour commander le robot orthogonal (500) sur la base des informations de position reçues.

3. Appareil d'inspection de soudure de cellule de batterie selon la revendication 1, dans lequel le pointeur laser (510) émet un faisceau laser vers une soudure de chacune d'une borne d'électrode positive et d'une borne d'électrode négative de la cellule de batterie défectueuse.

4. Appareil d'inspection de soudure de cellule de batterie selon la revendication 1, comprenant en outre :
un élévateur configuré pour régler une hauteur de la plaque (200), dans lequel l'élévateur est situé sous la plaque (200).

5. Appareil d'inspection de soudure de cellule de batterie selon la revendication 1, dans lequel la cassette de cellules de batterie (800) comprend quatre parties d'angle, dont chacune est formée par la jonction de deux surfaces latérales, et dans lequel l'unité d'alignement (300) aligne la cassette de cellules de batterie (800) tout en se déplaçant de manière à se rapprocher ou à s'éloigner des quatre parties d'angle.

6. Appareil d'inspection de soudure de cellule de batterie selon la revendication 1, dans lequel la plaque (200) comprend une partie d'accouplement (210) configurée pour fixer une position de la cassette de cellules de batterie (800).

7. Appareil d'inspection de soudure de cellule de batterie selon la revendication 1, comprenant en outre :
une unité d'affichage de comptage (400) configurée pour afficher le nombre des cellules de batterie défectueuses.

8. Appareil d'inspection de soudure de cellule de batterie selon la revendication 1, comprenant en outre :
un inspecteur manuel configuré pour permettre à un opérateur d'inspecter manuellement une soudure de la cellule de batterie défectueuse marquée par le pointeur laser (510).

9. Appareil d'inspection de soudure de cellule de batterie selon la revendication 8, dans lequel l'inspecteur manuel comprend :
un calibre de traction-poussée (610) configuré pour tirer un fil (810) de la soudure de la cellule de batterie défectueuse ; et
une unité d'alarme (620) configurée pour générer une alarme lorsqu'une force avec laquelle le calibre de traction-poussée (610) tire le fil (810) atteint un niveau défini.

10. Appareil d'inspection de soudure de cellule de batterie selon la revendication 7, dans lequel le nombre affiché sur l'unité d'affichage de comptage (400) est diminué chaque fois qu'un opérateur vérifie la soudure de la cellule de batterie défectueuse marquée par le pointeur laser (510).

11. Procédé d'inspection de soudure de cellule de batterie utilisant l'appareil d'inspection de soudure de cellule de batterie selon l'une quelconque des revendications 1 à 10, le procédé d'inspection de soudure de cellule de batterie comprenant :
la disposition d'une cassette de cellules de batterie (800) ayant une pluralité de cellules de batterie (801) montées à l'intérieur sur la plaque (200) ;
l'alignement d'une position de la cassette de cellules de batterie (800) à l'aide de l'unité d'alignement (300) ;
la transmission d'informations de position d'une soudure d'une cellule de batterie défectueuse au robot orthogonal (500) ;
le marquage de la soudure de la cellule de batterie défectueuse à l'aide du pointeur laser (510) par un mouvement du robot orthogonal (500) ; et
la traction de la soudure de la cellule de batterie défectueuse marquée par le pointeur laser (510) à l'aide de l'inspecteur manuel pour son inspection, dans lequel
les informations de position de la soudure de la cellule de batterie défectueuse sont obtenues à partir d'un résultat de mesure de la résistance interne de la cassette de cellules de batterie (800) et d'un résultat de mesure à l'aide du scanner d'imagerie thermique effectué à l'avance.

12. Procédé d'inspection de soudure de cellule de batterie selon la revendication 11, dans lequel, à l'achèvement d'une inspection manuelle d'une cellule spécifique parmi une pluralité de cellules de batterie défectueuses, un faisceau laser du pointeur laser (510) marque une autre cellule de batterie défectueuse, et dans lequel, lorsqu'il y a une autre cellule de batterie défectueuse après l'achèvement de l'inspection manuelle de l'autre cellule de batterie défectueuse, le faisceau laser est émis vers l'autre cellule de batterie défectueuse et l'autre cellule de batterie défectueuse est inspectée manuellement.

13. Procédé d'inspection de soudure de cellule de batterie selon la revendication 11, dans lequel le nombre des cellules de batterie défectueuses est affiché sur l'unité d'affichage de comptage (400) sous forme de chiffres, dans lequel le nombre sur l'unité d'affichage de comptage (400) diminue d'une unité chaque fois que le fil (810) de la soudure de la cellule de batterie défectueuse est tiré lors de l'étape d'inspection manuelle, et dans lequel un opérateur tire les fils (810) des soudures de toutes les cellules de batterie défectueuses pour inspecter les soudures jusqu'à ce que le nombre affiché sur l'unité d'affichage de comptage (400) atteigne zéro.

14. Procédé d'inspection de soudure de cellule de batterie selon la revendication 11, dans lequel l'étape d'inspection utilisant l'inspecteur manuel est effectuée par un processus de traction du fil (810) de la soudure de la cellule de batterie défectueuse jusqu'à ce que l'inspecteur manuel génère une alarme.
